# EUROPEAN PATENT APPLICATION

(11) **EP 2 169 094 A1**
(43) Date of publication of application: **31.03.2010**
(21) Application number: 08775431.3
(22) Date of filing: 04.06.2008
(51) Int. Cl.: C30B 7/00, C30B 30/08, B01D 9/02, C07B 55/00, C07B 57/00

(54) **METHOD FOR CRYSTALLISATION FROM A SOLUTION**

(30) Priority: 04.06.2007 ES 200701532
(71) Applicant: Institutio Nacional de Tecnica Aeroespacial " Esteban Terradas", 28850 Torrejon de Ardoz (Madrid) (ES); Consejo Superior De Investigaciones Cientificas, 28006 Madrid (ES)
(72) Inventor: OSUNA ESTEBAN, Susana, E-28805 Torrejon De Ardoz (Madrid) (ES); ZORZANO MIER, Mª, Paz, E-28805 Torrejon De Ardoz (Madrid) (ES); MENOR SALVÁN, Cesar, E-28805 Torrejon De Ardoz (Madrid) (ES); RUIZ BERMEJO, Marta, E-28805 Torrejon De Ardoz (Madrid) (ES); VEINTEMILLAS VERDAGUER, Sabino, E-28006 Madrid (ES)
(74) Representative: Carpintero Lopez, Francisco
(86) International application number: PCT/ES2008/000403
(87) International publication number: WO 2008/148912

(57) **Abstract**

The present invention relates to a novel method and to a device for obtaining crystals from a substance, comprising: (i) preparing a saturated dissolution of the substance to be crystallized in a suitable solvent in a reaction vessel; (ii) generating an aerosol in the reaction vessel; (iii) crystallizing the substance; and (iv) recovering the crystals at the bottom of the reaction vessel. The method is especially suitable for crystallizing substances which are typically difficult to crystallize and can lead to a chiral amplification result.

## Description

### Field of the Invention

The present invention relates to a method for crystallizing organic or inorganic chemical substances which allows obtaining crystals with perfect shapes and faces without signs of abrasion or breakage. Said method for crystallization takes place partially inside an aerosol in suspension generated from a saturated solution of the substance to be crystallized.

### Background of the Invention

There is a great interest both in organic and in inorganic chemistry in providing pure substances in the form of perfect crystals for the purpose of elucidating their structures by means of X-ray diffraction, in order to determine other properties such as chirality, catalytic properties, non-linear optical devices, etc.

In this sense, various alternative methods for the crystallization of various substances have been developed.

Patent KR2001003894 describes a process for crystallizing a specific product, phosphorescent aluminate, which comprises initially obtaining a precursor solution containing water, acids and specific activators as well as other products necessary for causing a reaction. An aerosol is then generated and a drying, reaction and crystallization process is applied in a reaction tube, the phosphorescent aluminate being obtained. Patent KR20010038293 describes a method similar to that of patent KR2001003894, useful for crystallizing another specific product, phosphorescent oxide.

Patent ES 2186551 B1 describes a method which allows directly obtaining by crystallization the two enantiomeric forms of chiral compounds such as, for example, the enantiomeric forms of the amino acid L- and D-aspartic acid and of L- and D-glutamic acid. The crystals are obtained by preparing a sub-saturated solution of the compound in question and introducing into the solution a porous material allowing the capillary rise of the solution. Thus, when the solution rises, it gradually evaporates and is supersaturated, such that the solute is concentrated until such a supersaturation is reached that it causes the nucleation and growth of crystals.

On the other hand, patent EP 0 244 867 describes a method and a device for crystallizing a substance in solution by means of conventional methods in a weightless condition. Although this method achieves crystals without structural defects, it has the drawback that the device for putting it into practice is complex and expensive.

Therefore, there is still a need in the state of the art to provide an alternative method for the crystallization of organic and inorganic chemical substances in general which allows obtaining perfect crystals quickly and simply and at a low cost.

In this sense, the inventors of the present invention have discovered a novel method for crystallization based on drastically increasing the area of the air-solution interface in a saturated solution of the substance to be crystallized. The method is based on a continuous micronization of part of the solution, a cloud being formed above it, formed by droplets with a micrometric size in which the step of crystallization initiation (primary nucleation) of the present invention takes place.

The inventors have discovered that in some cases the crystallization of certain substances occurs with chiral amplification and that the method likewise allows obtaining crystals from substances which are generally difficult to crystallize in conventional conditions in very long crystallization induction times.

### Object of the Invention

Therefore, one object of the present invention relates to a method for obtaining crystals of a substance, comprising the following steps:
- preparing a saturated solution of the substance to be crystallized in a suitable solvent;
- introducing said saturated solution in a reaction vessel;
- generating an aerosol in the reaction vessel, subjecting said saturated solution to ultrasonic waves;
- crystallizing the substance;
- recovering the crystals at the bottom of the reaction vessel.

Another object of the invention relates to a device suitable for crystallizing a substance comprising an aerosol generator and a reaction vessel.

### Description of the Drawings

Figure 1: shows a device suitable for carrying out the method of the invention comprising a reaction vessel containing the solution and the aerosol submerged in an ultrasound bath.
Figure 2 shows the formation of sodium chlorate crystals obtained according to the method of the invention, observed by means of a binocular loupe provided with polarizers. The arrows indicate the direction of rotation of the analyzer.
Figure 3 shows, on the same scale as the crystals shown in Figure 2, sodium chlorate crystals which are obtained with secondary nucleation by abrasion or breakage of the parent crystal, and observed by means of a binocular loupe provided with polarizers.
Figure 3a shows the formation of sodium chlorate crystals obtained according to the method described by Kondepudi (D.K. Kondepudi, R.J. Kaufman, N. Singh, Science, 250, 975-976(1990)).
Figure 3b shows the formation of sodium chlorate crystals obtained according to the method described by Viedma (C. Viedma, Phys.Rev.Lett. 94, 065504(4) (2005)).

### Description of the Invention

The present invention relates to a method for crystallizing both organic and inorganic chemical substances in general, and obtaining crystals with perfect shapes without signs of abrasion or breakage by means of primary nucleation in a quick, simple and reproducible manner.

Said method, hereinafter method of the invention, is useful for obtaining crystals of substances which would otherwise be difficult to crystallize. The method is likewise useful for causing crystallizations of certain substances with chiral amplification and thus obtaining the enantiomeric phases.

The method of the invention comprises the following steps:
(i) preparing a saturated solution of the substance to be crystallized in a suitable solvent;
(ii) introducing said saturated solution in a reaction vessel;
(iii) generating an aerosol in the reaction vessel, subjecting said saturated solution to ultrasonic waves;
(iv) crystallizing the substance;
(v) recovering the crystals at the bottom of the reaction vessel.

The method of the invention first requires (i) preparing a saturated precursor solution of the substance to be crystallized in a suitable solvent. Said solution is filtered and introduced in the reaction vessel (ii).

In general, any organic or inorganic chemical substance can be crystallized according to the method of the invention.

As used in this description, the term "suitable solvent" relates to a solvent in which the substance to be crystallized is soluble. Said solvent is easily selected in each case by the person skilled in the art depending on the chemical nature of the substance to be crystallized. The suitable solvent can be a solvent or a mixture of more than one solvent.

In general, water (for crystallizing inorganic substances) and organic solvents such as acetone, for crystallizing organic substances such as hippuric acid for example, can be mentioned among the suitable solvents to put the method of the invention into practice. The saturated solution can be easily prepared by a person skilled in the art, depending on the substance and the selected solvent, and it is prepared by dissolving the substance to be crystallized in a suitable vessel. In a particular embodiment, the solution is obtained with stirring and applying heat to facilitate the dissolution process.

Then, in step (iii) an aerosol is generated in the reaction vessel from the starting solution by means of using ultrasound waves which are used to generate vibrations in the surface of the solution and cause the formation of the aerosol.

As used in this description, the term "aerosol" relates to a suspension in air of microscopic droplets of the starting solution, such as a "mist" or "cloud". The aerosol particles generally have diameters comprised between 0.1 and 100 µm, and preferably less than 10 µm.

The aerosol increases the contact surface of the solution with air, and therefore intensifies the evaporation of the solvent and increases the concentration of the solute in the surface of the droplets of the solution, favoring the crystallization in the surface of the microscopic droplets in the air.

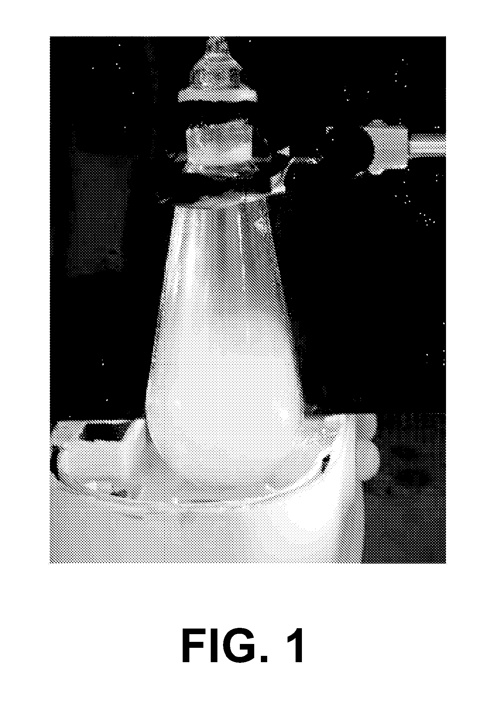

According to a particular embodiment of the present invention, step (iii) is carried out by submerging the reaction vessel containing the solution in a low-power ultrasound bath. In a preferred embodiment, the power is comprised between 25-30 W. The vibration is transmitted through the walls of the reaction vessel to the solution and particularly to the surface thereof, causing the formation of the aerosol (see Figure 1).

In a preferred embodiment, the reaction vessel is a glass flask with a thin bottom, so as to suitably transmit the ultrasonic vibration, with a thickness preferably comprised between 0.5-1.0 mm.

Crystallization step (iv) taking place in the method of the present invention is only a primary crystallization type step, i.e., each crystal is formed independently, from primary nucleation, and not by breakage of the parent crystal.

During the crystallization step, a continuous cycle from the aerosol phase, in which surface evaporation is intense and crystallization starts, to the liquid phase and vice versa is maintained, which makes molecules which are in solution in the liquid phase be continuously incorporated to the small crystals which are formed in the aerosol. In a particular embodiment, the temperature of the ultrasound bath is raised to a temperature comprised between 35-38ºC. The typical crystallization time necessary to obtain crystals observable in the binocular loupe is comprised between 3.5 and 4 hours for substances with short induction times and between 12 and 15 hours in cases of longer induction times (see examples).

The result of the method of the invention is obtaining perfect crystals (v), all of them with a similar size, without structural defects and without agglomerations.

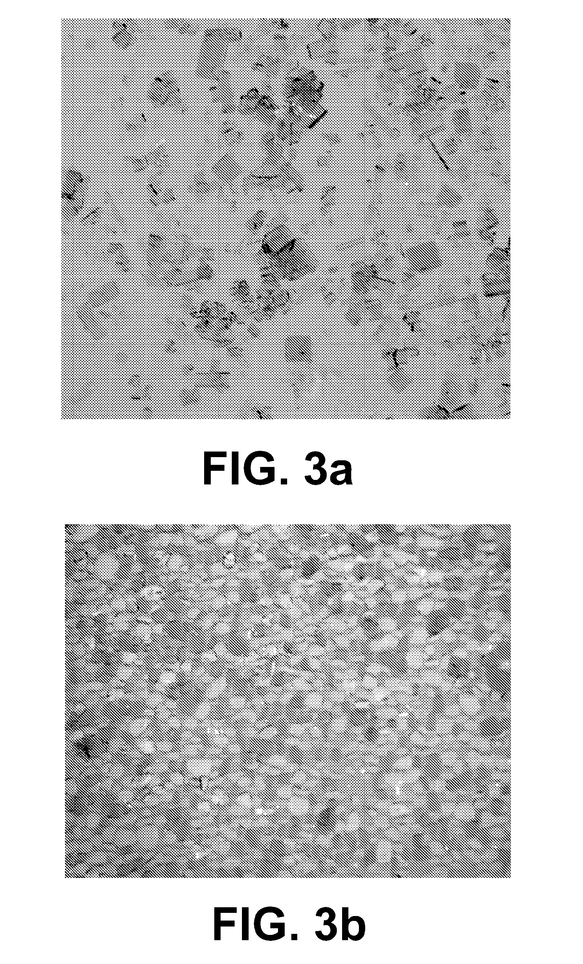

Sodium chlorate, NaClO₃, is crystallized in a particular embodiment. Four hours after the crystallization has started, cubic sodium chlorate crystals observable in the binocular loupe are obtained with a size comprised between 1.75-1.80 mm (in a measurement made in 50 crystals) with perfect faces, without signs of abrasion or breakage and chiral amplification. The resulting crystals differ from those obtained in the experiments described in Kondepudi (D.K. Kondepudi, R.J. Kaufman, N.Singh, Science, 250, 975-976(1990)) and Viedma (C. Viedma, Phys.Rev.Lett. 94, 065504(4) (2005)) in that in these case secondary nucleation takes place by abrasion or breakage of the parent crystal (see Figures 3a and 3b, respectively).

The chirality of the sodium chlorate crystals obtained in the method of the invention is determined by their optical activity using a stereo microscope and two linear polarizers. In the method of the invention, the breakage of the symmetry is 100%, i.e., only one of the two optical isomers, d or I, is obtained.

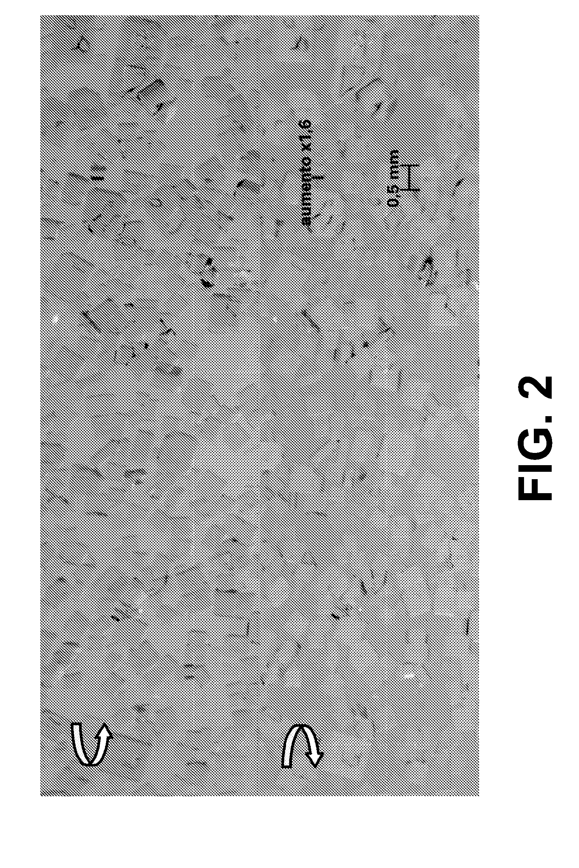

The fact that all the crystals have the same contrast in the image of Figure 2 indicates that all the crystals make the plane of polarized light rotate in the same direction, the symmetry being broken.

In contrast, the racemic situation would be that 50% of the crystals rotate the plane of light in one direction and the other half in the opposite direction.

In another particular embodiment, MgSO₄·7H₂O (magnesium sulfate heptahydrate) crystals, a substance difficult to crystallize by conventional methods, are obtained. Crystals with a significant size so as to be observable in the binocular loupe comprised between 1.75-1.80 mm (in a measurement made in 50 crystals) are recovered in the reaction vessel after 15 hours of crystallization, and it is observed that all of them are polyhedrons with perfect faces without signs of abrasion or breakage and all of them have approximately the same size. The result of the crystals clearly shows that secondary nucleation does not take place in the method of the invention.

In another particular embodiment, NaBrO₃ (sodium bromate) crystals with a significant size so as to be observable in the binocular loupe comprised between 1.75-1.80 mm (in a measurement made in 50 crystals) are obtained in the reaction vessel after 4 hours of crystallization and it is observed that all of them are tetrahedrons with perfect faces without signs of abrasion or breakage, and that they are obtained with chiral amplification. The chirality of the crystals is determined by their optical activity using a stereo microscope and 2 linear polarizers. In this case, the breakage of the symmetry is 100%.

In another particular embodiment, hippuric acid, C₉H₉NO₃, crystals with a significant size so as to be observable in the binocular loupe are obtained after 12 hours of crystallization. The crystallization of hippuric acid produces identical crystals without agglomerations, and much more quickly than the conventional manner which needs between 1 and 3 weeks to obtain millimetric crystals.

The method of the invention has several advantages. On one hand, the method takes place in environmental pressure and temperature conditions, in normal gravity conditions and in contact with air, therefore it is neither a risky nor an expensive method, nor does it require special conditions for putting it into practice. As shown in the examples, it is a very quick and effective method, especially when it is compared with crystallizations in conventional conditions.

The conditions in which is carried out are simple, in the sense that the device is not very expensive, has small dimensions, and the reaction vessel is a normal glass flask.

The crystallization takes place in a single sequence, in a single reaction vessel.

The method generally allows crystallizing a large variety of both organic and inorganic substances (see examples).

As has been mentioned, it has been observed that with the method of the invention, in addition to perfect crystals, 100% chiral amplification is achieved in some cases with some substances (see Examples 1 and 3).

The method is likewise especially advantageous for crystallizing substances which are typically difficult to crystallize such as those forming viscous solutions and/or needing long crystallization times. Examples of these substances are magnesium sulfate heptahydrate and hippuric acid (see Examples 2 and 4).

The method of the invention is carried out in a device forming another object of the present invention, to crystallize a substance comprising an aerosol generator and a reaction vessel. In a particular embodiment, the aerosol generator comprises an ultrasound bath and the reaction vessel is a glass flask which is submerged in said bath.

Illustrative examples of the invention are described below, set forth to better understand the invention, and in no case must they be considered as a limitation of the scope thereof.

### Examples

### Example 1: Method for crystallization of sodium chlorate in aqueous solution with aerosol with a chiral amplification result

A 5 ml solution was prepared from ultrapure water (Millipore Milli-Q Q. Gard), dissolving 4.88 g of NaClO₃ (sodium chlorate supplied by Sigma Aldrich S.A., ACS quality) in 5.12 g of Milli-Q water. This solution was stirred at 500 rpm and 45ºC for 15 minutes to ensure the complete dissolution of sodium chlorate. The solution was directly filtered to a 500 ml glass flask through sterile 5 ml syringes and also sterile 0.22 µm-pore nylon filters. The glass flask was placed in the ultrasound bath of the aerosol generator (BONECO, model 7131). The initial temperature was 30ºC but during the process the temperature of the ultrasound bath increased to 38ºC. A continuous cycling of the aerosol phase in which an intense surface evaporation takes place, giving rise to crystallization, occurred. After 4 hours, crystals with a significant size so as to be observable in the binocular loupe (1.75-1.80 mm in a measurement made in 50 crystals) were observed in the flask and it was observed that all of them were cubic crystals with perfect faces without signs of abrasion or breakage, in contrast to other crystallization experiments (Figures 3a and 3b), and with chiral amplification, such as the experiments described in Kondepudi (D.K. Kondepudi, R.J. Kaufman, N.Singh, Science, 250, 975-976(1990)) and Viedma (C. Viedma, Phys.Rev.Lett. 94, 065504(4) (2005)).

The chirality of the crystals was determined by their optical activity using a Stemi 2100 stereo microscope (ZEISS) provided with an Axio Cam MRc digital camera (ZEISS) and two photographic linear polarizing filters. In this case, the breakage of the symmetry was 100%, i.e., only one of the two optical isomers, d or I, is formed.

### Example 2: Method for crystallization of magnesium sulfate in aqueous solution with aerosol

A 21.89 ml solution was prepared from ultrapure water (Millipore Milli-Q Q. Gard), dissolving 5.70 g of MgSO_{4·}7H₂O (magnesium sulfate heptahydrate, supplied by Panreac, ACS quality) in 16.19 g of Milli-Q water. This solution was stirred at 500 rpm and 40ºC for 30 minutes to ensure the complete dissolution of magnesium sulfate. The solution was filtered directly to a 500 ml glass flask through sterile 5 ml syringes and also sterile 0.22 µm-pore nylon filters. The glass flask was placed in the ultrasound bath of the aerosol generator (BONECO, model 7131). The initial temperature was 30ºC but during the process the temperature of the ultrasound bath increased to 38ºC. A continuous cycling of the aerosol phase in which an intense surface evaporation takes place, giving rise to crystallization, occurred. After 15 hours, crystals with a significant size so as to be observable in the binocular loupe, with a size comprised between 1.75-1.80 mm (in a measurement made in 50 crystals), were observed in the flask. It was observed that all of them were polyhedrons with perfect faces without signs of abrasion or breakage occurring in the vessel, and that all of them had approximately the same size.

This fact ensures that secondary nucleation is not involved. The crystals were collected from the solution and photographed using a Stemi 2100 stereo microscope (ZEISS) provided with an Axio Cam MRc digital camera (ZEISS) and two photographic linear polarizing filters.

### Example 3: Method for crystallization of sodium bromate in aqueous solution with aerosol with a chiral amplification result

A 5 ml solution was prepared from ultrapure water (Millipore Milli-Q Q. Gard), dissolving 3.1 g of NaBrO₃ (sodium bromate supplied by Riedel-de Haen) in 6.9 g of Milli-Q water. This solution was stirred at 400 rpm and 35ºC for 15 minutes to ensure the complete dissolution of sodium bromate. The solution was directly filtered to a 500 ml glass flask through sterile 5 ml syringes and also sterile 0.22 µm-pore nylon filters. The glass flask was placed in the ultrasound bath of the aerosol generator (BONECO, model 7131). The initial temperature was 30ºC but during the process the temperature of the ultrasound bath increased to 38ºC. A continuous cycle of the aerosol phase in which an intense surface evaporation takes place, giving rise to crystallization, occurred. After 4 hours, crystals with a significant size so as to be observable in the binocular loupe, with a size comprised between 1.75-1.80 mm (in a measurement made in 50 crystals) were observed in the flask and it was observed that all of them were tetrahedrons with perfect faces without signs of abrasion or breakage, in contrast to other crystallization experiments with chiral amplification, such as the Kondepudi experiments. The chirality of the crystals was determined by their optical activity using a Stemi 2100 stereo microscope (ZEISS) provided with an Axio Cam MRc digital camera (ZEISS) and two photographic linear polarizing filters. In this case, the breakage of the symmetry was also 100%.

### Example 4: Method for crystallization of hippuric acid in aqueous solution with aerosol

A solution of hippuric acid in acetone (supplied by Merck, HPLC quality) was prepared, dissolving 3.7 g of C₉H₉NO₃ (hippuric acid supplied by Sigma-Aldrich) in 200 ml of acetone. This solution was stirred at 400 rpm and 30ºC for 30 minutes to ensure the complete dissolution of hippuric acid. Using glass syringes and special 0.2 µm filters for acetone 5 ml of the solution of hippuric acid were directly transferred to a 500 ml glass flask. The glass flask was placed in the ultrasound bath of the aerosol generator (BONECO, model 7131). The initial temperature was 30ºC but during the process the temperature of the ultrasound bath increased to 38ºC. A continuous cycle of the aerosol phase in which an intense surface evaporation takes place, giving rise to crystallization, occurred. After 12 hours, crystals with a significant size so as to be observable by means of a Stemi 2100 stereo microscope (ZEISS) provided with an Axio Cam MRc digital camera (ZEISS) and two photographic linear polarizing filters were observed in the flask.

The crystallization of hippuric acid is achieved with a primary crystallization (all the crystals being identical and without agglomerations) much more quickly than the usual manner which requires several days for evaporation, and even weeks until obtaining crystals with a millimetric size. This acid is particularly interesting as a chiral catalyst in organic reactions.

## Claims

1. Method for obtaining crystals of a substance comprising the following steps:
(i) preparing a saturated solution of the substance to be crystallized in a suitable solvent;
(ii) introducing said saturated solution in a reaction vessel;
(iii) generating an aerosol in the reaction vessel, subjecting said saturated solution to ultrasonic waves;
(iv) crystallizing the substance;
(v) recovering the crystals at the bottom of the reaction vessel.

2. Method according to claim 1, wherein the substance to be crystallized can be organic or inorganic.

3. Method according to claim 1, wherein the suitable solvent for preparing the solution in step (i) is selected from among organic solvents, inorganic solvents and mixtures thereof.

4. Method according to claim 1, wherein the saturated solution is selected from among sodium chlorate in water, magnesium sulfate heptahydrate in water, sodium bromate in water, and hippuric acid in acetone.

5. Method according to claim 1, wherein the reaction vessel is made of glass.

6. Method according to claim 5, wherein the reaction vessel is a glass flask with a bottom thickness comprised between 0.5 and 1.0 mm.

7. Method according to claim 1, wherein step (iii) is carried out by submerging the reaction vessel in an ultrasound bath.

8. Method according to claim 7, wherein step (iii) is carried out by submerging the reaction vessel in an ultrasound bath at a power comprised between 25 and 30 W.

9. Method according to claim 1, wherein the crystallization which takes place is a primary nucleation type crystallization.

10. Device for crystallizing a substance comprising an aerosol generator and a reaction vessel.

11. Device according to claim 10, wherein the aerosol generator comprises an ultrasound bath and the reaction vessel is a glass flask.
